# EUROPEAN PATENT APPLICATION

(11) **EP 3 866 318 A1**
(43) Date of publication of application: **18.08.2021**
(21) Application number: 21153719.6
(22) Date of filing: 27.01.2021
(51) Int. Cl.: H02M 1/08, H02M 1/084, H02M 7/48, H03K 17/691

(54) **INVERTER SYSTEM**

(30) Priority: 13.02.2020 US 202062975968 P
(71) Applicant: Delta Electronics, Inc., Neihu, Taipei 11491 (TW)
(72) Inventor: Zhou, Yan, 11491 Taipei (TW); Lin, Tsai-Sheng, 11491 Taipei (TW); Gui, Yingying, 11491 Taipei (TW); Wang, Ze, 11491 Taipei (TW); Klesyk, Krzysztof, 11491 Taipei (TW)
(74) Representative: Uexküll & Stolberg

(57) **Abstract**

An inverter system (1) is provided. The inverter system (1) has a first voltage zone (2) and a second voltage zone (3) isolated with each other. The inverter system (1) includes a power unit (11), a controller (12), a power regulator (13), an isolated power supply (14), a driver (15) and an inverter (16). The power unit (11) in the first voltage zone (2) provides an initial power. The controller (12) in the first voltage zone (2) generates a power control signal. The power regulator (13) in the first voltage zone (2) receives the power control signal and the initial power and outputs a first adjustable power accordingly. The isolated power supply (14) has a primary part (141) and a secondary part (142) in the first and second voltage zones (2, 3) respectively. The primary part (141) receives the first adjustable power, and the secondary part (142) outputs a second adjustable power. The driver (15) in the second voltage zone (3) receives the second adjustable power and outputs an adjustable driving signal to control the inverter (16).

## Description

### FIELD OF THE INVENTION

The present disclosure relates to an inverter system, and more particularly to an inverter system with isolated voltage zones.

### BACKGROUND OF THE INVENTION

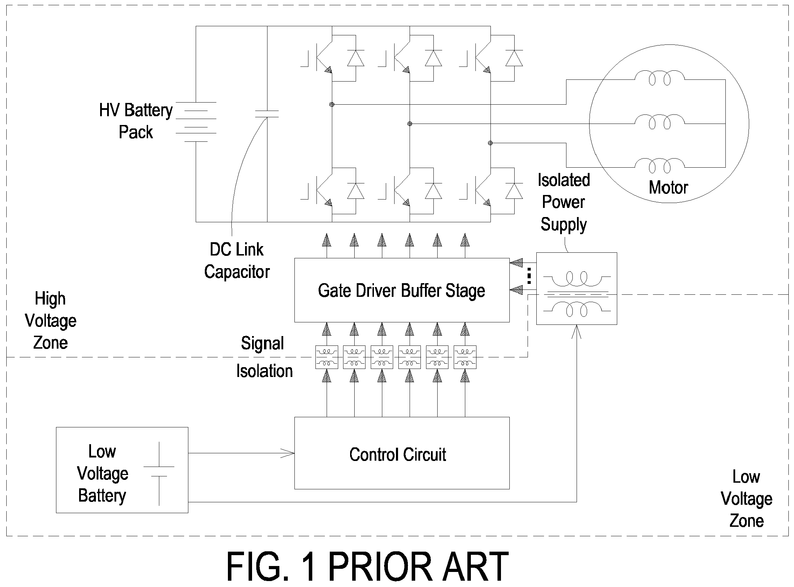

In electric vehicle or hybrid electric vehicle, a high voltage (HV) battery pack powers the electric motor which is coupled to drive wheels. Between the HV battery pack and the electric motor, there is an energy conversion unit, such as traction inverter. FIG. 1 shows a generic diagram of a three-phase voltage source inverter used for traction inverter application. The power stage of the inverter is mainly composed of a DC link capacitor and six switches. The switches are controlled by a control circuit whose signals are sent to the gate driver buffer stage through isolation channels. A voltage of +15V is usually provided to the gate driver buffer stage by the low voltage battery with 12V in the vehicle through an isolated power supply. There are total six isolated gate driver power supplies for six switches respectively.

It is noted that the low voltage battery and the control circuit are in a low voltage zone, while the HV battery pack, the power stage and the gate driver buffer stage are in a high voltage zone. Any signal or power transmission between the low voltage zone and the high voltage zone needs isolation.

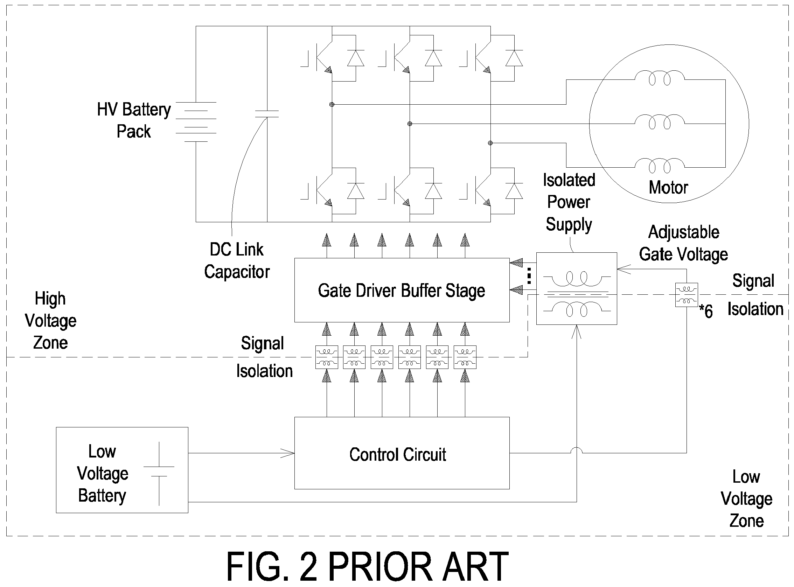

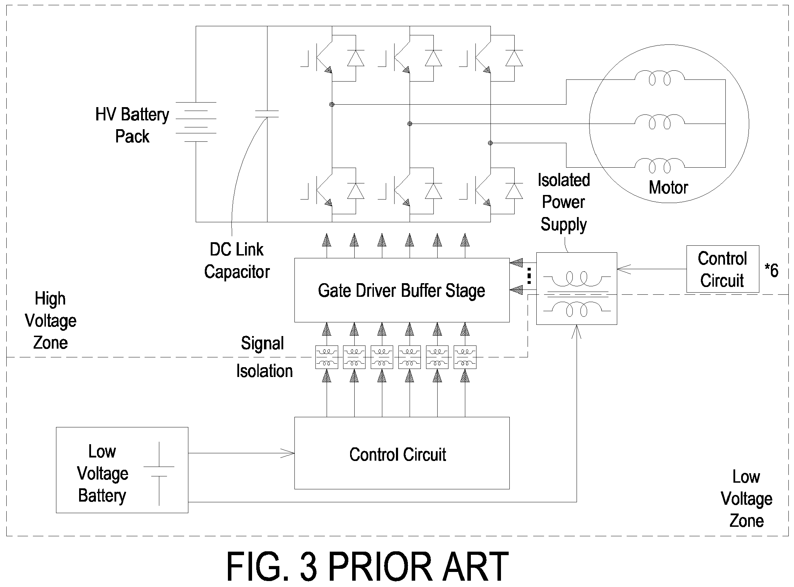

The gate voltage, which is used to drive the switch, highly impacts the switching and conduction performance. Usually the higher the gate voltage, the lower the switching loss and the lower the conduction. However, the higher gate voltage may cause higher device surge voltage stress during switching and cause higher EMI (electromagnetic interference) emission. Therefore, we may want to adjust the gate voltage at different operating points, for example different junction temperature, different load current, different dc link voltage, etc. One straightforward way is to achieve adjustable gate voltage by utilizing the control circuit. The control circuit has all inverter operating information, such as junction temperature, load current, dc link voltage, etc. Since the gate driver power supply and the control circuit are in high and low voltage zones respectively, six signal isolation channels are needed to control the six gate driver power supplies, as shown in FIG. 2. Another possible way is to add six control circuits in the high voltage zone for controlling the six gate driver power supplies respectively, as shown in FIG. 3. However, both methods shown in FIG. 2 and FIG. 3 involve quite significant cost increase.

Therefore, there is a need of providing an inverter system for power modules to obviate the drawbacks encountered from the prior arts.

### SUMMARY OF THE INVENTION

It is an objective of the present disclosure to provide an inverter system. The inverter system can achieve adjustable gate driver voltage by disposing one power regulator between the power unit and the isolated power supply, and the cost is much lower than that of the conventional approaches.

In accordance with an aspect of the present disclosure, there is provided an inverter system. The inverter system has a first voltage zone and a second voltage zone isolated with each other. The inverter system includes a power unit, a controller, a power regulator, an isolated power supply, a driver and an inverter. The power unit is in the first voltage zone and is configured to provide an initial power. The controller is in the first voltage zone and is configured to generate a power control signal. The power regulator is in the first voltage zone. The power regulator is electrically connected to the controller and the power unit for receiving the power control signal and the initial power, and the power regulator outputs a first adjustable power according to the power control signal. The isolated power supply has a primary part and a secondary part in the first and second voltage zones respectively. The primary part is electrically connected to the power regulator for receiving the first adjustable power, and the secondary part outputs a second adjustable power based on the first adjustable power. The driver is in the second voltage zone and is electrically connected to the secondary part of the isolated power supply for receiving the second adjustable power. The driver outputs an adjustable driving signal according to the second adjustable power. The inverter is in the second voltage zone and is electrically connected to the driver for receiving the adjustable driving signal. The inverter is controlled to perform a power conversion by the adjustable driving signal.

### BRIEF DESCRIPTION OF THE DRAWINGS

FIG. 1, FIG. 2 and FIG. 3 are schematic circuit diagrams showing conventional inverter systems;
FIG. 4 is a schematic circuit diagram illustrating an inverter system according to an embodiment of the present disclosure; and
FIG. 5 schematically shows a circuit diagram of the driver in FIG. 4.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed.

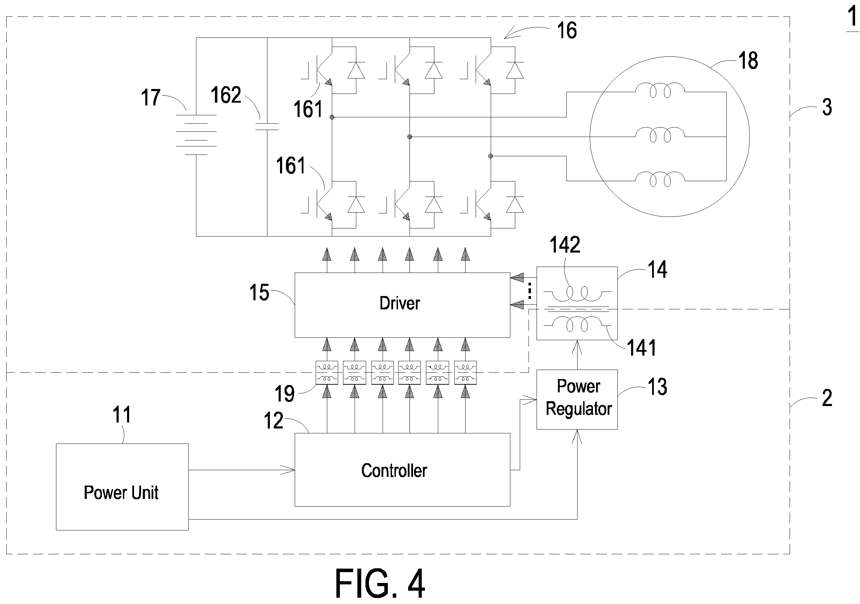

FIG. 4 is a schematic circuit diagram illustrating an inverter system according to an embodiment of the present disclosure. As shown in FIG. 4, the inverter system 1 has a first voltage zone 2 and a second voltage zone 3 isolated with each other. Preferably but not exclusively, the first and second voltage zone 2 and 3 are a low voltage zone and a high voltage zone respectively. The inverter system 1 includes a power unit 11, a controller 12, a power regulator 13, an isolated power supply 14, a driver 15 and an inverter 16. The power unit 11, the controller 12 and the power regulator 13 are in the first voltage zone 2. The isolated power supply 14 has a primary part 141 and a secondary part 142 in the first and second voltage zones 2 and 3 respectively. The driver 15 and the inverter 16 are in the second voltage zone 3.

The power unit 11 is configured to provide an initial power. The power unit 11 may be a low voltage battery, but not limited thereto. The controller 12 is configured to generate a power control signal. The power regulator 13 is electrically connected to the power unit 11 and the controller 12 for receiving the power control signal and the initial power. According to the power control signal, the power regulator 13 outputs a first adjustable power. Depending on the magnitude relation between the initial power and the first adjustable power, the power regulator 13 may be a buck converter or a buck-boost converter.

The primary part 141 of the isolated power supply 14 is electrically connected to the power regulator 13 for receiving the first adjustable power, and the secondary part 142 of the isolated power supply 14 outputs a second adjustable power based on the first adjustable power. In an embodiment, the primary and secondary parts 141 and 142 of the isolated power supply 14 are electromagnetically coupled to each other for transforming the first adjustable power into the second adjustable power. The isolated power supply 14 may be an isolated transformer, but not exclusively.

The driver 15 is electrically connected to the secondary part 142 of the isolated power supply 14 for receiving the second adjustable power, and the driver 15 outputs an adjustable driving signal according to the second adjustable power. In specific, the second adjustable power is the gate driver voltage of switches of the inverter 16.

The inverter 16 is electrically connected to the driver 15 for receiving the adjustable driving signal, and the inverter 16 is controlled to perform a power conversion by the adjustable driving signal. The inverter 16 is for example but not limited to a traction inverter.

Since the controller 12, the power regulator 13 and the primary part 141 of the isolated power supply 14 are all in the first voltage zone 2, there is no need for isolation. Further, the first adjustable power outputted by the power regulator 13 is controlled by the controller 12, and the isolated power supply 14 runs open loop (i.e., the ratio of the first adjustable power to the second adjustable power is fixed). Accordingly, as the first adjustable power outputted by the power regulator 13 changes, the second adjustable power (i.e., gate driver voltage) changes as well. Consequently, the inverter system 1 can achieve adjustable gate driver voltage by disposing only one power regulator 13 between the power unit 11 and the isolated power supply 14, and the cost is much lower than that of the conventional approaches.

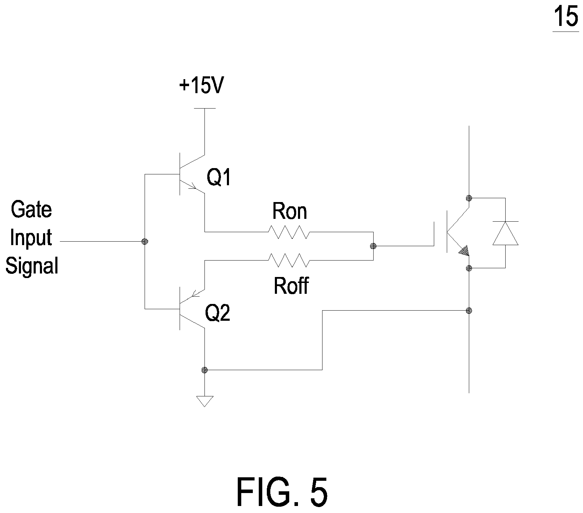

In an embodiment, as shown in FIG. 5, the driver 15 includes a NPN BJT Q1, a PNP BJT Q2, a turn-on gate resistor Ron and a turn-off gate resistor Roff. The gate driver power supply is for example but not limited to + 15V.

Please refer to FIG. 4 again. In an embodiment, the secondary part 142 of the isolated power supply 14 outputs a plurality of second adjustable powers based on the first adjustable power, and the driver 15 outputs a plurality of adjustable driving signals according to the plurality of second adjustable powers respectively. The inverter 16 includes a plurality of switches 161 (e.g., the six switches 161 of the inverter shown in FIG. 4) controlled by the plurality of adjustable driving signals respectively. It is noted that the numbers of the second adjustable powers and the adjustable driving signals are the same with the number of the switches 161 included by the inverter 16. The switch 161 is for example but not limited to IGBT (insulated gate bipolar transistor), MOSFET (metal-oxide-semiconductor field-effect transistor), BJT (bipolar junction transistor), SiC transistor or GaN transistor.

In an embodiment, the inverter system 1 further includes a power source 17 and an electric motor 18 in the second voltage zone 3. The inverter 16 is electrically connected between the power source 17 and the electric motor 18. The inverter 16 receives a DC power from the power source 17 and converts the DC power into an AC power according to the adjustable driving signal, and the inverter 16 outputs the AC power to the electric motor 18. The power source 17 may be a high-voltage battery pack, but not limited thereto. In an embodiment, the inverter 16 includes a DC link capacitor 162 connected to the power source 17 in parallel.

In an embodiment, the controller 12 transmits a switch control signal to the driver 15 through an isolation channel 19, and the driver 15 outputs the adjustable driving signal according to the second adjustable power and the switch control signal. The number of the isolation channels 19 is the same with the number of the switches 161 included by the inverter 16. The isolation channel 19 may be formed by disposing a signal isolator, but not limited thereto.

From the above descriptions, the present disclosure provides an inverter system. The inverter system can achieve adjustable gate driver voltage by disposing only one power regulator between the power unit and the isolated power supply, and the cost is much lower than that of the conventional approaches.

## Claims

1. An inverter system (1) having a first voltage zone (2) and a second voltage zone (3) isolated with each other, **characterized by** comprising:
a power unit (11), which is in the first voltage zone (2), configured to provide an initial power;
a controller (12), which is in the first voltage zone (2), configured to generate a power control signal;
a power regulator (13) in the first voltage zone (2), wherein the power regulator (13) is electrically connected to the controller (12) and the power unit (11) for receiving the power control signal and the initial power, and the power regulator (13) outputs a first adjustable power according to the power control signal;
an isolated power supply (14) having a primary part (141) and a secondary part (142) in the first and second voltage zones (2, 3) respectively, wherein the primary part (141) is electrically connected to the power regulator (13) for receiving the first adjustable power, and the secondary part (142) outputs a second adjustable power based on the first adjustable power;
a driver (15) in the second voltage zone (3), wherein the driver (15) is electrically connected to the secondary part (142) of the isolated power supply (14) for receiving the second adjustable power, and the driver (15) outputs an adjustable driving signal according to the second adjustable power; and
an inverter (16) in the second voltage zone (3), wherein the inverter (16) is electrically connected to the driver (15) for receiving the adjustable driving signal, and the inverter (16) is controlled to perform a power conversion by the adjustable driving signal.

2. The inverter system (1) according to claim 1, wherein the primary and secondary parts (141, 142) of the isolated power supply (14) are electromagnetically coupled to each other for transforming the first adjustable power into the second adjustable power.

3. The inverter system (1) according to claim 1, wherein a ratio of the first adjustable power to the second adjustable power is fixed.

4. The inverter system (1) according to claim 1, wherein the secondary part (142) of the isolated power supply (14) outputs a plurality of second adjustable powers based on the first adjustable power, the driver (15) outputs a plurality of adjustable driving signals according to the plurality of second adjustable powers respectively, the inverter (16) comprises a plurality of switches (161) controlled by the plurality of adjustable driving signals respectively.

5. The inverter system (1) according to claim 4, wherein the plurality of switches (161) are IGBTs, MOSFETs, BJTs, SiC transistors or GaN transistors.

6. The inverter system (1) according to claim 1, further comprising a power source (17) and an electric motor (18) in the second voltage zone (3), wherein the inverter (16) is electrically connected between the power source (17) and the electric motor (18), the inverter (16) receives a DC power from the power source (17) and converts the DC power into an AC power according to the adjustable driving signal, and the inverter (16) outputs the AC power to the electric motor (18).

7. The inverter system (1) according to claim 6, wherein the inverter (16) comprises a DC link capacitor (162) connected to the power source (17) in parallel.

8. The inverter system (1) according to claim 1, wherein the controller (12) transmits a switch control signal to the driver (15) through an isolation channel (19), and the driver (15) outputs the adjustable driving signal according to the second adjustable power and the switch control signal.

9. The inverter system (1) according to claim 1, wherein the first and second voltage zone (2, 3) are a low voltage zone and a high voltage zone respectively.

10. The inverter system (1) according to claim 1, wherein the inverter (16) is a traction inverter.
